# EUROPÄISCHE PATENTSCHRIFT

(11) **EP 2 722 648 B1**
(45) Veröffentlichungstag und Bekanntmachung des Hinweises auf die Patenterteilung: **03.10.2018**
(21) Anmeldenummer: 13177628.8
(22) Anmeldetag: 23.07.2013
(51) Int. Cl.: H01L 23/552, G01B 7/00, G01D 5/244, G01D 3/08, G01D 5/347

(54) **Absolutes Positionsmessgerät**
Absolute position measuring device
Appareil de mesure de position absolu

(30) Priorität: 17.10.2012 DE 102012218890
(43) Veröffentlichungstag der Anmeldung: 23.04.2014
(73) Patentinhaber: Dr. Johannes Heidenhain GmbH, 83301 Traunreut (DE)
(72) Erfinder: Auer, Daniel, 83278 Traunstein (DE); Bratzdrum, Erwin, 83362 Surberg (DE)

(56) Entgegenhaltungen:
- WO-A2-02/31432
- DE-A1- 2 550 378
- DE-A1-102006 004 898
- DE-A1-102011 006 424

## Beschreibung

Die Erfindung betrifft ein absolutes Positionsmessgerät nach Anspruch 1. Ein derartiges absolutes Positionsmessgerät ist geeignet, in Anlagen oder Maschinen eingesetzt zu werden, in denen es hochenergetischer, ionisierender Strahlung ausgesetzt ist.

Positionsmessgeräte werden in verschiedensten technischen Gebieten benötigt, um bei Anlagen und Maschinen die Position (Länge oder/und Winkel) beweglicher Komponenten zu bestimmen. Derartige Positionsmessgeräte werden aufgrund ihres Funktionsprinzips in zwei Gruppen unterschieden, zum einen gibt es inkrementale Positionsmessgeräte, bei denen die Positionsermittlung auf dem Zählen von Teilungsperioden einer Inkrementalteilung basiert, zum anderen absolute Positionsmessgeräte, bei denen die Position durch Abtastung und Auswertung einer Absolutteilung gewonnen wird.

Inkrementale Positionsmessgeräte weisen gegenüber absoluten Positionsmessgeräten einen einfachen, robusten Aufbau auf, haben aber den Nachteil, dass unmittelbar nach dem Einschalten keine Positionsinformation vorhanden ist und erst durch eine sog. Referenzfahrt eine Referenzmarke überfahren werden muss, um auf die absolute Position schließen zu können. In vielen technischen Bereichen werden deshalb mittlerweile bevorzugt absolute Positionsmessgeräte eingesetzt, bei denen jederzeit, auch unmittelbar nach dem Einschalten, ein absoluter Positionswert zur Verfügung steht. Ein absolutes Positionsmessgerät ist beispielsweise in der EP 0 660 209 A1 beschrieben.

Ein technischer Bereich, bei dem der Einsatz absoluter Positionsmessgeräte nach wie vor problematisch ist, sind Anlagen oder Maschinen, die ionisierender, hochenergetischer Strahlung ausgesetzt sind, oder deren Anwendungsgebiet den Einsatz derartiger Strahlung erfordert. Insbesondere sei hier die Medizintechnik genannt, wo ionisierende, hochenergetische Strahlung gezielt eingesetzt wird, um Krankheiten zu heilen oder deren Fortschreiten zu verzögern. Vorwiegend wird hier Gammastrahlung, Röntgenstrahlung oder Teilchenstrahlung (Protonen, Neutronen, Elektronen, etc.) verwendet.

Es hat sich gezeigt, dass sich inkrementale Positionsmessgeräte, die derartiger Strahlung ausgesetzt sind, aufgrund ihres einfachen Aufbaus recht robust verhalten. Absolute Positionsmessgeräte dagegen, die zur Ermittlung eines absoluten Positionswerts einen komplexeren Aufbau erfordern, neigen dazu auszufallen, wenn sie ionisierender, hochenergetischer Strahlung ausgesetzt werden.

Soll dennoch ein absolutes Positionsmessgerät in einem derartigen Umfeld, beispielsweise in einem Gerät der Medizintechnik zur Bestrahlung von Tumorgewebe, eingesetzt werden, stehen bisher zwei Lösungsansätze zur Verfügung, zum einen die Abschirmung des absoluten Positionsmessgeräts vor der schädlichen Strahlung, zum anderen der Aufbau des Positionsmessgeräts aus sog. strahlungsharten Komponenten, also Komponenten, die speziell für dieses Einsatzgebiet entwickelt wurden. Beide Ansätze sind in der Praxis unbefriedigend. Abschirmungen gegenüber nicht-ionisierender elektromagnetischer Strahlung sind beispielsweise aus DE102011006424 und WO0231432 bekannt. Diese Abschirmungen sind allerdings bekanntlich nicht für den hier vorliegenden Zweck geeignet oder hinreichend. Um eine ausreichende

Abschirmwirkung zu erzielen, wird eine zentimeterdicke Bleiummantelung benötigt, die hauptsächlich aufgrund ihres Gewichts, aber auch wegen des großen Platzbedarfs, unerwünscht ist. Strahlungsharte Komponenten sind, im Vergleich zu Standardkomponenten, meist unverhältnismäßig teuer und nur in großen Gehäusen verfügbar. Ein absolutes Positionsmessgerät aus strahlungsharten Komponenten aufzubauen, hätte somit eine große Bauform und einen sehr hohen Preis zur Folge. Außerdem sind nicht alle benötigten, oder gewünschten Komponenten in strahlungsharter Ausführung erhältlich.

Es ist daher Aufgabe der Erfindung, ein absolutes Positionsmessgerät mit einfachem Aufbau zu schaffen, das für den Einsatz in einer Umgebung geeignet ist, in der es ionisierender Strahlung ausgesetzt ist.

Diese Aufgabe wird gelöst durch ein absolutes Positionsmessgerät nach Anspruch 1. Vorteilhafte Details eines derartigen absoluten Positionsmessgeräts ergeben sich aus den von Anspruch 1 abhängigen Ansprüchen.

Es wird nun ein absolutes Positionsmessgerät vorgeschlagen, umfassend
- eine erste Baugruppe, mit einer Maßverkörperung, auf der wenigstens eine Codespur angeordnet ist und einer Abtasteinheit, mit der durch Abtastung der wenigstens einen Codespur in einer Messrichtung Positionssignale erzeugbar sind, aus denen ein absoluter, digitaler Positionswert generierbar ist und
- eine zweite Baugruppe, mit wenigstens einer Peripherieeinheit, ausgebildet zur Ausführung einer Zusatz- oder Hilfsfunktion des Positionsmessgeräts,
wobei die erste Baugruppe und die zweite Baugruppe zur Übertragung elektrischer Signale mittels einer Mehrzahl elektrischer Leitungen miteinander verbunden sind und die erste Baugruppe ausschließlich Komponenten umfasst, die für den Einsatz in einem Strahlungsbereich einer Maschine geeignet sind.

Weitere Vorteile sowie Einzelheiten der vorliegenden Erfindung ergeben sich aus der nachfolgenden Beschreibung anhand der Figuren. Dabei zeigt
- Figur 1a: eine vereinfachte Darstellung eines medizinischen Bestrahlungsgeräts in der Draufsicht,
- Figur 1b: eine vereinfachte Darstellung eines medizinischen Bestrahlungsgeräts in der Seitenansicht,
- Figur 2: ein Blockdiagramm einer ersten Ausführungsform erfindungsgemäßen Positionsmessgeräts und
- Figur 3: ein Blockdiagramm einer zweiten Ausführungsform erfindungsgemäßen Positionsmessgeräts.

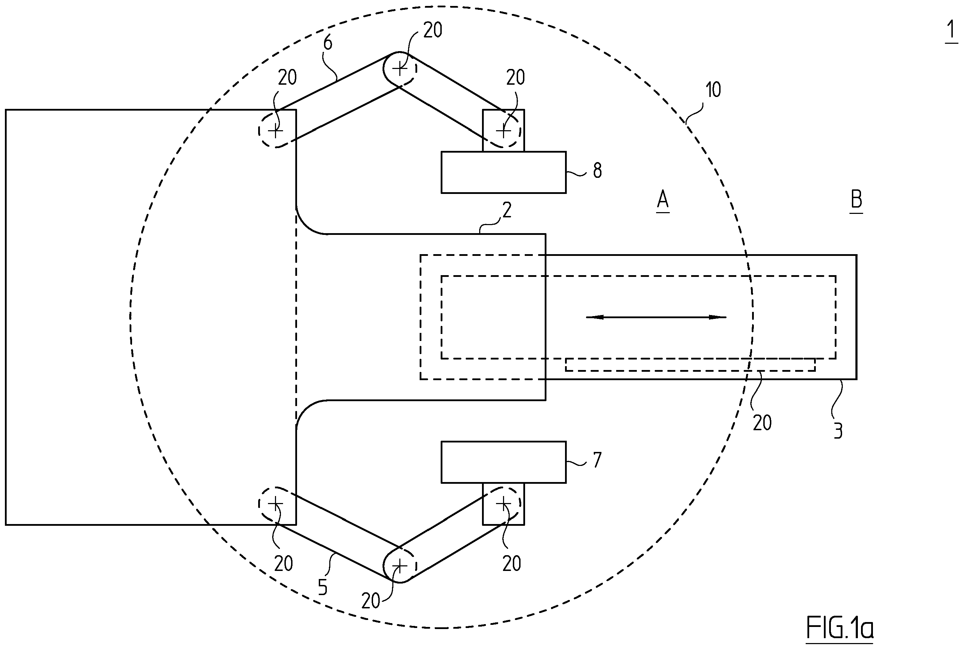

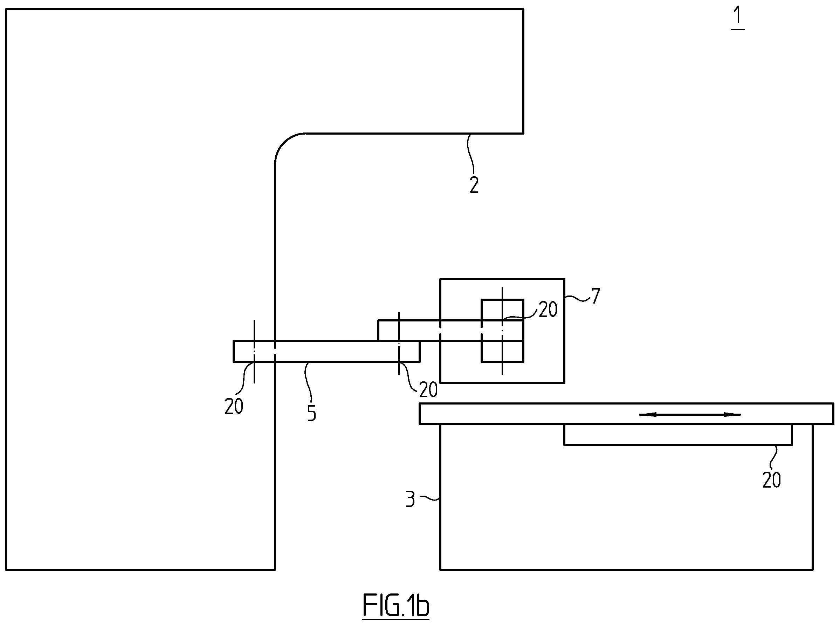

Die Figuren 1a und 1b zeigen als Beispiel für eine Anlage, in der ionisierende, hochenergetische Strahlung, insbesondere Gammastrahlung, Röntgenstrahlung oder Elektronenstrahlung, zum Einsatz kommt, eine vereinfachte Darstellung einer Draufsicht (Figur 1a) und einer Seitenansicht (Figur 1b) eines medizinischen Bestrahlungsgeräts 1. Eine Strahlenquelle 2 des Bestrahlungsgeräts 1 befindet sich oberhalb des gezeichneten Kopfendes einer Patientenliege 3. Dabei wurde der Übersichtlichkeit halber auf eine detaillierte Darstellung der Strahlenquelle verzichtet, es soll angenommen werden, dass die ionisierende, hochenergetische Strahlung, die beispielsweise zur Bestrahlung eines Tumors verwendet wird, vorwiegend innerhalb des in Figur 1a gezeichneten Kreises 10 auftreten kann. Die Fläche innerhalb des Kreises 10 wird daher im Folgenden als Strahlungsbereich A bezeichnet. Außerhalb des Strahlungsbereichs A und somit des Kreises 10 befindet sich ein strahlungssicherer Bereich B.

Selbstverständlich ist diese Unterteilung stark vereinfacht und dient vorwiegend zur Beschreibung der vorliegenden Erfindung. In der Praxis nimmt die Energie der auftretenden Strahlung mit steigendem Abstand von der Strahlungsquelle ab, es kann also keine exakte Grenzlinie gezogen werden. Für die folgenden Ausführungen wird unter der Bezeichnung Strahlungsbereich A der Bereich einer Anlage verstanden, in dem ionisierende, hochenergetische Strahlung in einer Dosis auftreten kann, die die Funktionssicherheit eines herkömmlichen absoluten Positionsmessgeräts beeinträchtigen kann. Als strahlungssicherer Bereich B wird dagegen der Bereich um eine Anlage bezeichnet, in dem die Funktionssicherheit herkömmlicher absoluter Positionsmessgeräte nicht von der auftretenden Strahlung beeinträchtigt wird.

Neben der Einhaltung eines bestimmten Mindestabstands von der Strahlungsquelle kann ein strahlungssicherer Bereich B auch geschaffen werden, indem in Ausbreitungsrichtung der Strahlung eine abschirmende Barriere eingebracht wird. Ein besonders geeignetes Material hierfür ist Blei.

Am medizinischen Bestrahlungsgerät sind zwei Roboterarme 5 und 6 angeordnet, wobei der erste Roboterarm 5 eine Sendeeinheit 7 und der zweite Roboterarm 6 eine Empfangseinheit 8 eines Computertomographen (CT) trägt. Die Roboterarme 5, 6 dienen zur präzisen Positionierung der Sendeeinheit 7 und der Empfangseinheit 8 mit Hilfe von Servomotoren (nicht dargestellt), ihre Position wird mit Positionsmessgeräten 20, insbesondere Drehgebern oder Winkelmessgeräten, bestimmt, die in den Gelenken der Roboterarme 5, 6 angeordnet sind.

Die Patientenliege ist in Richtung des eingezeichneten Pfeils verfahrbar ausgeführt, ihre Position wird mit einem weiteren Positionsmessgerät 20, insbesondere einem Längenmessgerät, gemessen.

In derartigen medizinischen Bestrahlungsgeräten wird zum Teil bereits eine Strahlungsenergie von mehr als 20 MeV verwendet. Über die Lebensdauer einer solchen Anlage kann somit eine erhebliche Strahlungsdosis in die Positionsmessgeräte 20 eingebracht werden. Bei der eingesetzten Strahlung kann es sich um Gammastrahlung, Röntgenstrahlung oder Teilchenstrahlung (Protonen, Neutronen, Elektronen, etc.) handeln.

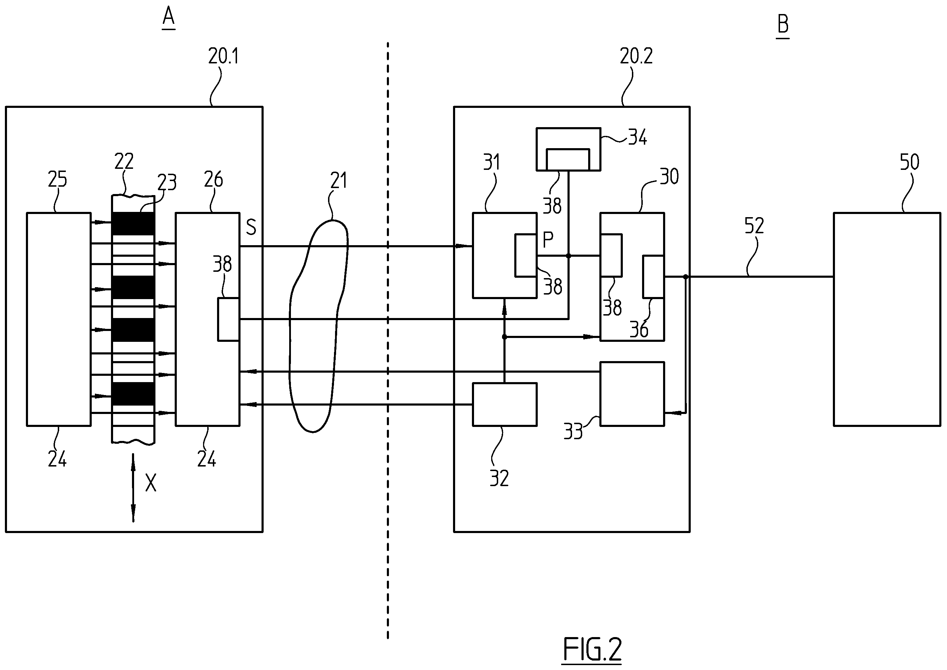

Figur 2 zeigt ein Blockdiagramm eines erfindungsgemäßen Positionsmessgeräts 20, das für den Einsatz in einer Anlage, in der das Positionsmessgerät 20 einer ionisierenden, hochenergetischen Strahlung ausgesetzt sein kann, geeignet ist. Das Positionsmessgerät 20 besteht aus einer ersten Baugruppe 20.1 und einer zweiten Baugruppe 20.2. Zur Übertragung elektrischer Signale zwischen der ersten Baugruppe 20.1 und der zweiten Baugruppe 20.2 sind diese über eine Mehrzahl von elektrischen Leitungen 21 miteinander verbunden.

Die erste Baugruppe 20.1 umfasst zur Erzeugung von Positionssignalen S, die zu einem absoluten Positionswert P verarbeitbar sind, eine Maßverkörperung 22 mit wenigstens einer Codespur 23, sowie eine Abtasteinheit 24 zur Abtastung der wenigstens einen Codespur 23. Die Codespur 23 kann parallel (z.B. Gray-Code) oder, wie in Figur 2 angedeutet, seriell codiert sein (Pseudo Random Code; PRC). Die Codierung kann aber auch analog ausgeführt sein, etwa durch mehrere parallel angeordnete Codespuren 23, die eine unterschiedliche Teilungsperiode aufweisen (Schwebungs- oder Noniusprinzip). Die Maßverkörperung 22 und die Abtasteinheit 24 sind in einer Messrichtung X relativ zueinander beweglich angeordnet.

Handelt es sich bei dem Positionsmessgerät 20 um ein Längenmessgerät, so ist die Maßverkörperung 22 beispielsweise ein Maßstab, auf dem die Codespur 23 aufgebracht ist. Bei einem Drehgeber oder Winkelmessgerät ist die Maßverkörperung 22 üblicherweise als kreisförmige Scheibe ausgeführt und die Codespur 23 ist ringförmig um den Mittelpunkt der Scheibe angeordnet.

In diesem Ausführungsbeispiel wird angenommen, dass das Positionsmessgerät 20 nach dem optischen Durchlichtprinzip arbeitet, d.h. die Positionsinformation der Codespur 23 ist durch eine Folge von lichtdurchlässigen und lichtundurchlässigen Bereichen codiert und die Abtasteinheit 24 umfasst eine Lichtquelle 25, die auf einer Seite der Maßverkörperung 22 angeordnet ist und die Licht in Richtung der Codespur 23 abstrahlt und eine Detektoreinheit 26, die aus dem durch die Codespur 23 modulierten Licht die Positionssignale S generiert. Die Positionssignale S können sowohl analog, als auch digital vorliegen und sind geeignet, aus ihnen einen absoluten, digitalen Positionswert P zu generieren.

Neben dem optischen Abtastprinzip sind auch andere Abtastprinzipien einsetzbar, insbesondere magnetische, kapazitive oder induktive. Ebenso kann ein optisches Auflichtprinzip zum Einsatz kommen, bei dem die Codespur 23 aus reflektierenden und nicht reflektierenden Bereichen besteht und deshalb die Lichtquelle 25 und die Detektoreinheit 26 auf einer Seite der Maßverkörperung 22 angeordnet sind.

Erfindungsgemäß sind alle Komponenten der ersten Baugruppe 20.1 des Positionsmessgeräts 20 so ausgeführt, dass sie für den Einsatz in einem Strahlungsbereich A einer Maschine geeignet sind. In Figur 2 befindet sich der Strahlungsbereich A links von der senkrechten, gestrichelten Linie.

Die zweite Baugruppe 20.2 umfasst Peripherieeinheiten des Positionsmessgeräts 20, die Zusatz- oder Hilfsfunktionen ausführen. Beispielsweise kann die zweite Baugruppe 20.2 eine Kommunikationseinheit 30, eine Signalverarbeitungseinheit 31, eine Reset-Einheit 32, eine Spannungsversorgungseinheit 33 und eine Speichereinheit 34 umfassen.

Die Kommunikationseinheit 30 stellt auf der einen Seite eine digitale Geräteschnittstelle 36 zur Verfügung, über die die Kommunikation mit einer Steuerungseinheit 50 erfolgt. Die Geräteschnittstelle 36 umfasst zum einen die physikalischen Voraussetzungen für die Kommunikation (Signalpegel, Datenrate, Steckverbinder,...) und zum anderen ein Kommunikationsprotokoll, das die Kommunikationsregeln zwischen dem Positionsmessgerät 20 und der Steuerungseinheit 50 festlegt. Mit Vorteil ist die Geräteschnittstelle 36 als eine serielle, insbesondere synchron-serielle Schnittstelle ausgeführt, wobei die Signale in bekannter Weise differentiell, beispielsweise nach dem RS-485-Standard, übertragen werden. Die zweite Baugruppe 20.2 und die Steuerungseinheit 50 sind über ein geeignetes Datenübertragungskabel 52 miteinander verbunden.

Auf der anderen Seite stellt die Kommunikationseinheit 30 eine interne Schnittstelle 38 zur Verfügung, die zur Kommunikation mit Peripherieeinheiten der zweiten Baugruppe 20.2 (im dargestellten Beispiel mit der Signalverarbeitungseinheit 31 und der Speichereinheit 34), oder aber mit der ersten Baugruppe 20.1 (beispielsweise der Abtasteinheit 24, bzw. der Detektoreinheit 26) dienen kann. Auch die interne Schnittstelle 38 stellt die physikalischen Voraussetzungen für die Kommunikation bereit und kann ein Schnittstellenprotokoll umfassen. Die Datenübertragung kann parallel oder seriell erfolgen. Selbstverständlich weisen alle Komponenten, die mit der internen Schnittstelle 38 der Kommunikationseinheit 30 kommunizieren, ebenfalls eine interne Schnittstelle 38 auf. Da es vorteilhaft ist, wenn die Kommunikation von der Kommunikationseinheit 30 gesteuert ist, ist die interne Schnittstelle 38 der Kommunikationseinheit 30 bevorzugt als sog. Master-Schnittstelle, und die interne Schnittstelle 38 der weiteren Komponenten als Slave-Schnittstelle ausgeführt.

Die Signalverarbeitungseinheit 31 dient dazu, aus den Positionssignalen S, die der zweiten Baugruppe 20.2 von der ersten Baugruppe 20.1 über die elektrischen Leitungen 21 zugeführt werden, einen digitalen, absoluten Positionswert P zu generieren und diesen, ggf. als Antwort auf einen Positionsanforderungsbefehl der Steuerungseinheit 50, über die interne Schnittstelle 38 an die Kommunikationseinheit 30 zu übertragen. Die Funktionen der Signalverarbeitungseinheit 31 können hierfür Analog-DigitalWandlung, Erkennung von fehlerhaften Positionssignalen S, Auswahl gültiger Signale aus einer Anzahl redundanter Positionssignale S, etc. umfassen.

Die Funktion der Reset-Einheit 32 kann beispielsweise die Überwachung der Versorgungsspannung des Positionsmessgeräts 20 und die Ausgabe eines Resetsignals im Falle von Schwankungen der Versorgungsspannung umfassen, um undefinierte Betriebszustände zu verhindern. Die Reset-Einheit 32 sorgt unter anderem auch dafür, dass nach dem Einschalten des Positionsmessgeräts 20 der Normalbetrieb erst dann freigegeben wird, wenn die Versorgungsspannung einen bestimmten Spannungspegel stabil überschritten hat. Auch das Resetsignal kann sowohl Peripherieeinheiten der zweiten Baugruppe 20.2 (im dargestellten Beispiel der Kommunikationseinheit 30 und der Signalverarbeitungseinheit 31), als auch über die elektrischen Leitungen 21 der ersten Baugruppe 20.1 zugeführt sein.

Die Spannungsversorgungseinheit 33 dient dazu, eine Versorgungsspannung, die dem Positionsmessgerät 20 beispielsweise über das Datenübertragungskabel 52 von der Steuerungseinheit 50 zugeführt wird, zu stabilisieren und/oder den Spannungspegel an die Erfordernisse der Komponenten des Positionsmessgeräts, bzw. der ersten Baugruppe 20.1 und der zweiten Baugruppe 20.2 anzupassen. Hierzu kann es erforderlich sein, dass die Spannungsversorgungseinheit 33 mehrere verschiedene Ausgänge ggf. mit unterschiedlichen Spannungen zur Verfügung stellt und über die elektrischen Leitungen 21 an die erste Baugruppe 20.1 überträgt. Ebenso kann die Spannungsversorgungseinheit 33 geeignet sein, aus einer variablen Eingangsspannung eine oder mehrere konstante Ausgangsspannungen zu erzeugen.

Die Speichereinheit 34 wird in Positionsmessgeräten 20 häufig verwendet, um Daten, die für den Betrieb des Positionsmessgeräts 20 relevant sind, abzuspeichern. Insbesondere können Parameter des Positionsmessgeräts 20 in der Speichereinheit 34 abgelegt sein. Beispiele hierfür sind Messsystem-Typ, Seriennummer, Auflösung, Datenformat, Drehrichtung des Messsystems, Kalibrierdaten, etc. Die Speichereinheit 34 kann über die interne Schnittstelle 38 ausgelesen und ggf. auch beschrieben werden. Speicherinhalte können darüber hinaus über die interne Schnittstelle 38 auch an die erste Baugruppe 20.1 übertragen werden. Der Zugriff auf die Speichereinheit 34 von der Steuereinheit 50 kann über die Geräteschnittstelle 36 und die interne Schnittstelle 38 unter Vermittlung der Kommunikationseinheit 30 erfolgen.

Die zweite Baugruppe 20.2 des Positionsmessgeräts 20 ist im strahlungssicheren Bereich B (rechts von der gestrichelten Linie) angeordnet. Es ist somit nicht notwendig, die Komponenten der zweiten Baugruppe 20.2 mit strahlungsresistenten (strahlungsharten) Komponenten auszustatten.

Der Kerngedanke der vorliegenden Erfindung ist es also, dass Komponenten, deren Funktion nicht unmittelbar zur Erzeugung der Positionssignale S, bzw. der absoluten Positionswerte P, beiträgt, auch räumlich getrennt von der ersten Baugruppe 20.1 angeordnet werden können. Diese Erkenntnis eröffnet die Möglichkeit, lediglich die Komponenten der ersten Baugruppe 20.1 so auszuführen, dass sie im Strahlungsbereich A ohne Beeinträchtigung durch die ionisierende, hochenergetische Strahlung betreibbar sind und dagegen die Komponenten der zweiten Baugruppe 20.2 in konventioneller Technik auszuführen.

Dadurch kann eine signifikante Kostenersparnis erzielt werden, da Komponenten in konventioneller Technik im Vergleich zu strahlungsresistenten (strahlungsharten) Komponenten um ein Vielfaches preisgünstiger eingekauft werden können. Darüber hinaus weisen konventionelle Komponenten eine bessere Verfügbarkeit auf. Außerdem sind nicht alle benötigten Komponenten auch in strahlungsresistenter Ausführung erhältlich. Als besonders problematisch haben sich hier Speicherbausteine herausgestellt.

Neben den Vorteilen in Bezug auf Preis und Verfügbarkeit der eingesetzten Komponenten, kann bei einem erfindungsgemäßen Positionsmessgerät 20 der Platzbedarf der ersten Baugruppe 20.1 im Vergleich zu herkömmlichen Positionsmessgeräten unter Umständen sogar noch reduziert werden, da in der ersten Baugruppe 20.1 nur noch sehr wenige Komponenten enthalten sind.

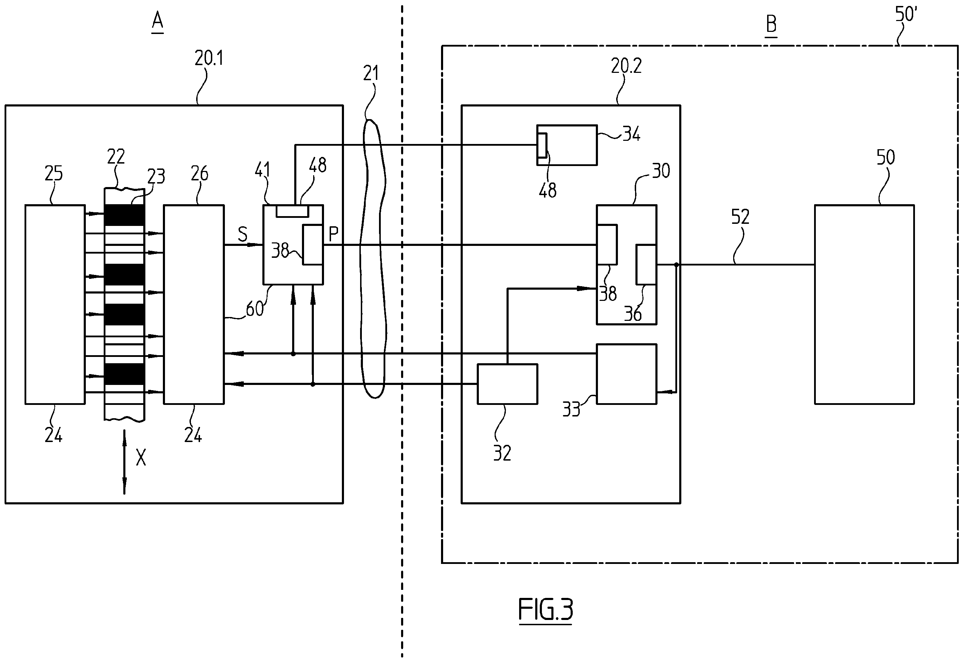

Figur 3 zeigt ein Blockdiagramm eines weiteren Ausführungsbeispiels eines erfindungsgemäßen Positionsmessgeräts 20. Komponenten, die bereits in Verbindung mit dem anhand von Figur 2 beschrieben wurden, tragen das gleiche Bezugszeichen und werden nicht noch einmal beschrieben.

Abweichend zum Ausführungsbeispiel nach Figur 2 ist jetzt eine Signalverarbeitungseinheit 41 in der ersten Baugruppe 20.1 angeordnet. Dies hat den besonderen Vorteil, dass nun bereits in der ersten Baugruppe 20.1 ein digitaler, absoluter Positionswert P erzeugt wird, der über die interne Schnittstelle 38 zur Kommunikationseinheit 30 der zweiten Baugruppe übertragen werden kann. Dadurch, dass die Datenübertragung jetzt im Rahmen eines Datenübertragungsprotokolls erfolgt, kann durch geeignete Maßnahmen, die dem Fachmann an sich bekannt sind (z.B. Erzeugung und Übertragung von Prüfsummen, etc.), eine sichere Übertragung der digitalen, absoluten Positionswerte P zur ersten Baugruppe 20.1 gewährleistet werden. Dies gilt besonders dann, wenn der räumliche Abstand zwischen der ersten Baugruppe 20.1 und der zweiten Baugruppe 20.2, bedingt durch den Abstand zwischen dem Strahlungsbereich A und dem strahlungssicheren Bereich B groß (mehrere Meter) ist.

Um bei der Datenübertragung zwischen der Signalverarbeitungseinheit 41 und der Kommunikationseinheit 30 eine möglichst große Störsicherheit zu erreichen, wird für die physikalische Übertragung auch bei der internen Schnittstelle 38 bevorzugt eine differentielle Datenübertragung, z.B. nach dem bekannten RS-485-Standard, eingesetzt. Da entsprechende Treiberbausteine allerdings die oben bereits erwähnten Nachteile aufweisen (hoher Preis, problematische Verfügbarkeit, große Bauform), kann physikalische Übertragung der Daten auch mittels massebezogener Digitalsignale erfolgen. In jedem Fall sind die elektrischen Leitungen 21, über die die Datenübertragung erfolgt, an die gewählte physikalische Übertragung anzupassen.

Neben der internen Schnittstelle 38 weist die Signalverarbeitungseinheit 41 noch eine separate Speicherschnittstelle 48 auf, über die die Signalverarbeitungseinheit 41 direkt mit einer entsprechenden Speicherschnittstelle 48 der Speichereinheit 34 in der zweiten Baugruppe 20.2 verbunden ist. Dadurch kann die Signalverarbeitungseinheit 41 direkt, ohne Umweg über die Kommunikationseinheit 30, Speicherinhalte der Speichereinheit 34 auslesen oder schreiben. Als Speicherschnittstelle wird mit Vorteil eine Schnittstelle eingesetzt, die in handelsüblichen Speichereinheiten 34 bereits verfügbar ist, beispielsweise eine I2C-Schnittstelle. Ein Zugriff auf die Speichereinheit 34 durch die Folgeelektronik 50 kann in diesem Ausführungsbeispiel über die Kommunikationseinheit 30 und die Signalverarbeitungseinheit 41 mit Hilfe der Geräteschnittstelle 36, der internen Schnittstelle 38 und der Speicherschnittstelle 48 erfolgen. Alternativ können Kommunikationseinheit 30 und Speichereinheit 34 aber auch über eine separate Schnittstelle verbunden sein, um eine direkte Kommunikation ohne den Umweg über die erste Baugruppe 20.1 zu ermöglichen. Auch für die Datenübertragung zwischen Signalverarbeitungseinheit 41 und Speichereinheit 34 sind geeignete elektrische Leitungen 21 vorgesehen.

Sind die Geräteschnittstelle 36 und die interne Schnittstelle 38 identisch ausgeführt, so kann die Kommunikationseinheit 30 auch lediglich die elektromechanische Verbindung (Steckverbinder und elektrische Leitungen) zwischen Geräteschnittstelle 36 und interner Schnittstelle 38 umfassen. Ebenso besteht die Möglichkeit, dass in der zweiten Baugruppe 20.2 überhaupt keine Kommunikationseinheit 30 vorgesehen ist und die Steuerungseinheit 30 direkt mit dem Datenübertragungskabel 52 mit der ersten Baugruppe 20.1 verbunden ist.

Die in Figur 3 gewählte Aufteilung ist deshalb besonders günstig, weil in modernen Positionsmessgeräten 20 häufig die Detektoreinheit 24 und die Signalverarbeitungseinheit 41 mit den entsprechenden Schnittstellen 38, 48 gemeinsam in einem hochintegrierten Baustein 60 (ASIC, bzw. im Fall einer optischen Abtastung, Opto-ASIC) integriert sind. Das bedeutet, dass lediglich der hochintegrierte Baustein für den Einsatz in einer Anlage, in der das Positionsmessgerät 20 einer ionisierenden, hochenergetischen Strahlung ausgesetzt sein kann, ertüchtigt werden muss, da die verbleibenden Komponenten der ersten Baugruppe - Lichtquelle 25 und Maßverkörperung 22 - die Eignung für den Einsatz im Strahlungsbereich A bereits ohne notwendige Änderungen aufweisen.

Wie in Figur 3 angedeutet, kann die zweite Baugruppe 20.2 in einem eigenen Gehäuse räumlich getrennt von der Folgeelektronik 50 angeordnet sein. Dies hat den besonderen Vorteil, dass die Folgeelektronik 50 überhaupt nicht "wissen" muss, dass das Positionsmessgerät 20 aus zwei Baugruppen besteht. Es ist dadurch besonders einfach, bei Anlagen, in denen bereits absolute Positionsmessgeräte eingesetzt sind, die durch aufwendige Abschirmungsmaßnahmen (z.B. Bleiummantelung) vor der auftretenden Strahlung geschützt sind, diese Positionsmessgeräte durch erfindungsgemäße Positionsmessgeräte 20 auszutauschen und das unerwünschte Gewicht der Abschirmung zu entfernen. Es muss lediglich darauf geachtet werden, dass die Geräteschnittstelle 36 kompatibel ist.

Abweichend davon ist es aber, wie durch den strichpunktiert gezeichneten Block angedeutet, auch möglich, die zweite Baugruppe 20.2 in eine Folgeelektronik 50' zu integrieren.

Die vorliegende Erfindung ist selbstverständlich nicht auf die beschriebenen Ausführungsbeispiele eingeschränkt.

## Patentansprüche

1. Absolutes Positionsmessgerät (20) umfassend
• eine erste Baugruppe (20.1), mit einer Maßverkörperung (22), auf der wenigstens eine Codespur (23) angeordnet ist und einer Abtasteinheit (24), mit der durch Abtastung der wenigstens einen Codespur (23) in einer Messrichtung (X) Positionssignale (S) erzeugbar sind, aus denen ein absoluter, digitaler Positionswert (P) generierbar ist und
• eine zweite Baugruppe (20.2), mit wenigstens einer Peripherieeinheit (30, 31, 32, 33, 34), ausgebildet zur Ausführung einer Zusatz- oder Hilfsfunktion des Positionsmessgeräts (20), sowie einer digitalen Geräteschnittstelle (36) zur Kommunikation mit einer Steuerungseinheit (50),
wobei die erste Baugruppe (20.1) und die zweite Baugruppe (20.2) zur Übertragung elektrischer Signale mittels einer Mehrzahl elektrischer Leitungen (21) miteinander verbunden sind und die erste Baugruppe (20.1) ausschließlich Komponenten (22, 25, 26, 41) umfasst, die für den Einsatz in einem Strahlungsbereich (A) einer Maschine, in dem ionisierende Strahlung auftritt, geeignet sind.

2. Absolutes Positionsmessgerät (20) nach Anspruch 1, wobei die zweite Baugruppe (20.1) weiter eine Signalverarbeitungseinheit (41) umfasst, mit der aus den Positionssignalen (S) der digitale Positionswert (P) generierbar ist.

3. Absolutes Positionsmessgerät (20), nach Anspruch 2, wobei die Signalverarbeitungseinheit (41) eine interne Schnittstelle (38), geeignet zur Übertragung des digitalen Positionswerts (P) zu einer Kommunikationseinheit (30) in der zweiten Baugruppe (20.2), aufweist.

4. Absolutes Positionsmessgerät nach einem der Ansprüche 2 oder 3, wobei die Signalverarbeitungseinheit (41) eine Speicherschnittstelle (48) aufweist, mit der Speicherinhalte einer Speichereinheit (34), die in der zweiten Baugruppe (20.2) angeordnet ist, lesbar und/oder schreibbar sind.

5. Absolutes Positionsmessgerät (20) nach einem der Ansprüche 2 bis 4, wobei die in Anspruch 1 genannten Komponenten eine Detektoreinheit (26) und die Signalverarbeitungseinheit (41) umfassen und diese beiden Komponenten als ein hochintegrierter Baustein (60) ausgeführt sind.

## Claims

1. Absolute position measuring device (20) comprising
• a first assembly (20.1), having a material measure (22), on which at least one code track (23) is arranged, and a scanning unit (24), by means of which position signals (S) are generatable by scanning the at least one code track (23) in a measuring direction (X), from which position signals an absolute, digital position value (P) is generatable, and
• a second assembly (20.2), having at least one peripheral unit (30, 31, 32, 33, 34), configured for performing an additional or auxiliary function of the position measuring device (20), and also a digital device interface (36) for communication with a control unit (50),
wherein the first assembly (20.1) and the second assembly (20.2) are connected to one another for transmission of electrical signals by means of a plurality of electrical lines (21) and the first assembly (20.1) exclusively comprises components (22, 25, 26, 41) which are suitable for use in a radiation region (A) of a machine in which radiation region ionizing radiation occurs.

2. Absolute position measuring device (20) according to Claim 1, wherein the second assembly (20.1) further comprises a signal processing unit (41), by means of which the digital position value (P) is generatable from the position signals (S).

3. Absolute position measuring device (20) according to Claim 2, wherein the signal processing unit (41) has an internal interface (38), suitable for transmitting the digital position value (P) to a communication unit (30) in the second assembly (20.2).

4. Absolute position measuring device according to either of Claims 2 or 3, wherein the signal processing unit (41) has a memory interface (48), by means of which memory contents of a memory unit (34) arranged in the second assembly (20.2) are readable and/or writable.

5. Absolute position measuring device (20) according to any of Claims 2 to 4, wherein the components mentioned in Claim 1 comprise a detector unit (26) and the signal processing unit (41) and these two components are embodied as a highly integrated module (60) .

## Revendications

1. Appareil de mesure de position absolue (20), comprenant
un premier sous-ensemble (20.1), muni d'une mesure matérialisée (22), sur laquelle est disposée au moins une piste codée (23), et une unité de palpage (24) qui, par palpage de l'au moins une piste codée (23) dans une direction de mesure (X), permet de produire des signaux de position (S) à partir desquels peut être générée une valeur de position (P) numérique absolue et
un deuxième sous-ensemble (20.2), muni d'au moins une unité périphérique (30, 31, 32, 33, 34), configurée pour exécuter une fonction supplémentaire ou auxiliaire de l'appareil de mesure de position (20), ainsi qu'une interface d'appareil (36) numérique servant à la communication avec une unité de commande (50),
le premier sous-ensemble (20.1) et le deuxième sous-ensemble (20.2) étant reliés l'un à l'autre au moyen d'une pluralité de lignes électriques (21) en vue de la transmission de signaux électriques et le premier sous-ensemble (20.1) comprend exclusivement des composants (22, 25, 26, 41) qui sont adaptés à une utilisation dans une zone de rayonnement (A) d'une machine dans laquelle est produit un rayonnement ionisant.

2. Appareil de mesure de position absolue (20) selon la revendication 1, le deuxième sous-ensemble (20.2) comprenant en outre une unité de traitement de signal (41) à l'aide de laquelle la valeur de position (P) numérique peut être générée à partir des signaux de position (S).

3. Appareil de mesure de position absolue (20) selon la revendication 2, l'unité de traitement de signal (41) possédant une interface interne (38) adaptée à la transmission de la valeur de position (P) numérique vers une unité de communication (30) dans le deuxième sous-ensemble (20.2).

4. Appareil de mesure de position absolue selon l'une des revendications 2 ou 3, l'unité de traitement de signal (41) possédant de mémoire (48) avec laquelle peuvent être lus et/ou écrits les contenus de mémoire d'une unité de mémoire (34) qui est disposée dans le deuxième sous-ensemble (20.2).

5. Appareil de mesure de position absolue (20) selon l'une des revendications 2 à 4, les composants mentionnés dans la revendication 1 comprenant une unité de détection (26) et une unité de traitement de signal (41) et ces deux composants étant réalisés sous la forme d'un module (60) à haut niveau d'intégration.
